(19) Europäisches Patentamt
European Patent Office
Office européen des brevets

(11) **EP 4 333 229 A2**

(12) **EUROPÄISCHE PATENTANMELDUNG**

(43) Veröffentlichungstag:
**06.03.2024 Patentblatt 2024/10**

(21) Anmeldenummer: 23194772.2

(22) Anmeldetag: **01.09.2023**

(51) Internationale Patentklassifikation (IPC):
**H02H 3/34** (2006.01)        **H02H 3/04** (2006.01)

(52) Gemeinsame Patentklassifikation (CPC):
**H02H 3/343; G01R 31/088; G01R 31/52;**
G01R 29/16; G01R 29/18; H02H 3/042

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **05.09.2022 DE 102022209203**

(71) Anmelder: **Siemens Aktiengesellschaft**
**80333 München (DE)**

(72) Erfinder:
• **Cox, Benjamin**
**1040 Wien (AT)**
• **Bouda, Fabian**
**1040 Wien (AT)**
• **Gawlik, Wolfgang**
**1040 Wien (AT)**

(74) Vertreter: **Siemens Patent Attorneys**
**Postfach 22 16 34**
**80506 München (DE)**

(54) **VERFAHREN UND SCHUTZGERÄT ZUM ERKENNEN EINES DOPPELERDSCHLUSSES IN EINEM LEITUNGSABSCHNITT EINER DREIPHASIGEN ELEKTRISCHEN ENERGIEÜBERTRAGUNGSLEITUNG**

(57) Die Erfindung bezieht sich unter anderem auf ein Verfahren zum Erkennen eines Doppelerdschlusses in einem Leitungsabschnitt (30) einer dreiphasigen elektrischen Energieübertragungsleitung, wobei bei dem Verfahren Phasenspannungszeiger ($\underline{U}_{A,Ph1}$ - $\underline{U}_{A,Ph3}$) gebildet werden, und zwar auf der Basis von Phase-Erde-Spannungen, die für die Phasenleiter (31-33) gemessen worden sind, und unter Berücksichtigung der Phasenspannungszeiger auf das Vorliegen oder Nichtvorliegen eines Doppelerdschlusses geschlossen wird. Erfindungsgemäß ist vorgesehen, dass mit den Phasenspannungszeigern ($\underline{U}_{A,Ph1}$ - $\underline{U}_{A,Ph3}$) nach der Methode der Symmetrischen Komponenten drei Systemzeiger, nämlich ein Mitsystemzeiger (U1), ein Gegensystemzeiger (U2) und ein Nullsystemzeiger (U0), errechnet werden, unter Heranziehung der Systemzeiger ein Auslösezeiger (K) errechnet wird und auf das Vorliegen eines Doppelerdschlusses geschlossen wird, wenn der Betrag (k) des Auslösezeigers (K) ein vorgegebenes Betragskriterium erfüllt und der Zeigerwinkel ($\alpha$) des Auslösezeigers (K) ein vorgegebenes Winkelkriterium erfüllt.

FIG 1

**(Forts. nächste Seite)**

# FIG 2

**Beschreibung**

Die Erfindung bezieht sich unter anderem auf ein Verfahren zum Erkennen eines Doppelerdschlusses in einem oder mehreren Leitungsabschnitten eines Systems mit dreiphasigen elektrischen Energieübertragungsleitungen, wobei bei dem Verfahren Phasenspannungszeiger gebildet werden, und zwar auf der Basis von Phase-Erde-Spannungen, die für die Phasenleiter der Energieübertragungsleitung gemessen worden sind, und unter Berücksichtigung der Phasenspannungszeiger auf das Vorliegen oder Nichtvorliegen eines Doppelerdschlusses geschlossen wird.

Bei vorbekannten Verfahren wird für die Unterscheidung eines Doppelerdschlusses von einem Einfacherdschluss die Asymmetrie der Leiter-Leiter-Spannungen der drei Phasen L1-L2-L3 analysiert. Dazu wird der kleinste Wert der drei Leiter-Leiter-Spannungen vom größten Wert abgezogen und das Ergebnis auf den größten Wert bezogen. Überschreitet dieser "Unsymmetrieparameter" einen bestimmten Wert, so wird das als Kriterium für einen Doppelerdschluss verwendet. Die physikalische Motivation für dieses Kriterium ist, dass es bei einem einpoligen Erdschluss in Netzen mit isoliertem, kompensiertem oder hochohmig geerdetem Sternpunkt zwar zu einer Sternpunktverlagerung und damit zu einer Unsymmetrie der Leiter-Erde-Spannungen kommt, aber die Außenleiterspannungen (Leiter-Leiter-Spannungen) weitgehend unverändert bleiben und deswegen keine Unsymmetrie in den Außenleiterspannungen auftritt. Erst wenn mehr als ein Leiter betroffen ist, kommt es zu einer Verzerrung des sonst gleichseitigen Dreiecks der Außenleiterspannungen und damit zu einem Wert des Unsymmetrieparameters, der größer als Null wird. Die Einstellung eines Schwellenwertes für den Unsymmetrieparameter, ab dem auf Doppelerdschluss entschieden wird, ist allerdings nicht einfach und auch nicht aus einer vorgegebenen Berechnungsvorschrift ableitbar. Oftmals wird deswegen der in Handbüchern zu Schutzgeräten genannte Standardwert 0,25 verwendet. Es kommt dann aber manchmal vor, dass Doppelerdschlüsse nicht richtig erkannt werden können.

Die Phasenbestimmung der von dem Doppelerdschluss betroffenen Phasen erfolgt bei bisherigen Verfahren häufig auf Basis der während des Fehlers gemessenen Leiterströme, die sich aus den Lastströmen und den zusätzlichen Fehlerströmen zusammensetzen. Insbesondere bei großen Lastströmen (also in stark belasteten Netzen, z. B. zu Zeiten großer Lasten oder wenn zahlreiche starke dezentrale Erzeuger aktiv sind) und verhältnismäßig kleinen Fehlerströmen (also in Netzen mit niedriger Kurzschlussleistung und durch Leistungselektronik begrenzten Fehlerstrombeiträgen) kann sich die Phasenbestimmung schwierig gestalten.

Der Erfindung liegt die Aufgabe zugrunde, ein zuverlässiges, aber dennoch einfach durchführbares Verfahren zum Erkennen eines Doppelerdschlusses anzugeben.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass mit den Phasenspannungszeigern nach der Methode der Symmetrischen Komponenten drei Systemzeiger, nämlich ein Mitsystemzeiger, ein Gegensystemzeiger und ein Nullsystemzeiger, errechnet werden, unter Heranziehung der Systemzeiger ein Auslösezeiger errechnet wird und auf das Vorliegen eines Doppelerdschlusses geschlossen wird, wenn der Betrag des Auslösezeigers ein vorgegebenes Betragskriterium erfüllt und der Zeigerwinkel des Auslösezeigers ein vorgegebenes Winkelkriterium erfüllt.

Die Erfindung geht von folgenden erfinderseitigen Erkenntnissen aus: Bei einem einpoligen Fehler kommt es elektrisch an der Fehlerstelle zu einer Reihenschaltung von Mit-, Gegen- und Nullsystem, durch die der resultierende Fehlerstrom fließen muss. In isolierten, kompensierten oder hochohmig geerdeten Netzen ist dieser Fehlerstrom wegen der verhältnismäßig hohen Impedanz im Nullsystem klein (Erdschluss statt Erdkurzschluss). Gleichzeitig entsteht wegen dieser hohen Impedanz der überwiegende Teil des Spannungsfalls im Nullsystem (und bewirkt eine Verlagerung des Sternpunktes), aber wegen der im Gegensatz dazu viel kleineren Impedanz im Gegensystem fast keine Gegensystemspannung. Bei einem zweipoligen Fehler kommt es dagegen elektrisch an der Fehlerstelle zu einer Reihenschaltung von Mit- und Gegensystem, bei einem zweipoligen Fehler mit Erdberührung zu einer Reihenschaltung von Mit- und der Parallelschaltung von Gegen- und Nullsystem. Ein Doppelerdschluss weist beide Charakteristika in gemischter Form auf; dies wird von dem erfindungsgemäßen Verfahren durch das Heranziehen des in der beschriebenen Weise bestimmten Auslösezeigers in besonders einfacher Weise und sehr effizient genutzt, um Doppelerdschlüsse (Nullsystem und Gegensystem in der Spannung) von einpoligen Fehlern (nur Nullsystem in der Spannung) und zweipoligen Fehlern ohne Erdberührung (nur Gegensystem in der Spannung) zu unterscheiden.

Vorteilhaft ist es, wenn der Auslösezeiger eine dimensionslose Größe ist und die Berechnung des Auslösezeigers die Division zumindest zweier der drei Systemzeiger umfasst.

Die Berechnung des Auslösezeigers schließt vorzugsweise die Multiplikation zweier der Systemzeiger unter Bildung eines Zeigerprodukts ein.

Bei der letztgeannten Variante ist es voteilhaft, wenn die Berechnung des Auslösezeigers die Division des Zeigerprodukts durch das Quadrat des dritten der drei Systemzeiger einschließt.

Alternativ oder zusätzlich kann in vorteilhafter Weise vorgesehen sein, dass die Berechnung des Auslösezeigers die Multiplikation des Nullsystemzeigers und des Gegensystemzeigers einschließt.

Auch kann die Berechnung des Auslösezeigers die Division des Zeigerprodukts durch das Quadrat des Mitsystemzeigers einschließen.

Das Betragskriterium wird vorzugsweise als erfüllt angesehen, wenn der Betrag des Auslösezeigers größer als ein vorgegebener Betragsschwellenwert ist.

Der Betragsschwellenwert liegt vorzugsweise zwischen 0,01 und 0,1.

Das Winkelkriterium wird vorzugsweise als erfüllt angesehen, wenn der Winkel des Auslösezeigers in einem vorgegebenen Winkelbereich liegt.

Im Falle, dass auf einen Doppelerdschluss geschlossen wird, wird vorzugsweise ein Quotientenzeiger gebildet, indem einer der drei Systemzeiger durch einen anderen der drei Systemzeiger dividiert wird, geprüft wird, in welchem von drei vorgegebenen 120°-Kreissektoren, die gemeinsam einen Vollkreis in der komplexen Ebene bilden, der Quotientenzeiger liegt und anhand der Lage des Quotientenzeigers auf die zwei vom Doppelerdschluss betroffenen Phasenleiter geschlossen wird.

Der Quotientenzeiger wird vorzugsweise durch Division des Gegensystemzeigers durch den Mitsystemzeiger gebildet.

Die Erfindung bezieht sich darüber hinaus auf ein Schutzgerät zum Erkennen eines Doppelerdschlusses in einem Leitungsabschnitt einer dreiphasigen elektrischen Energieübertragungsleitung, wobei das Schutzgerät dazu ausgestaltet ist, Phasenspannungszeiger zu bilden, und zwar auf der Basis von Phase-Erde-Spannungen, die für die Phasenleiter der Energieübertragungsleitung gemessen worden sind, und unter Berücksichtigung der Phasenspannungszeiger auf das Vorliegen oder Nichtvorliegen eines Doppelerdschlusses zu schließen.

Erfindungsgemäß ist bezüglich des Schutzgeräts vorgesehen, dass es derart ausgestaltet ist, dass es mit den Phasenspannungszeigern nach der Methode der Symmetrischen Komponenten drei Systemzeiger, nämlich einen Mitsystemzeiger, einen Gegensystemzeiger und einen Nullsystemzeiger, errechnet, unter Heranziehung der Systemzeiger einen Auslösezeiger errechnet und auf das Vorliegen eines Doppelerdschlusses schließt, wenn der Betrag des Auslösezeigers ein vorgegebenes Betragskriterium erfüllt und der Zeigerwinkel des Auslösezeigers ein vorgegebenes Winkelkriterium erfüllt. Bezüglich der Vorteile des erfindungsgemäßen Schutzgeräts und dessen vorteilhafter Ausgestaltungen sei auf die obigen Ausführungen im Zusammenhang mit dem erfindungsgemäßen Verfahren und dessen vorteilhafter Ausgestaltungen verwiesen.

Das Schutzgerät umfasst vorzugsweise eine Recheneinrichtung und einen Speicher. In dem Speicher ist vorzugsweise ein Softwareprogramm bzw. Softwareprogrammprodukt abgespeichert, das bei Ausführung durch die Recheneinrichtung die oben im Zusammenhang mit dem erfindungsgemäßen Verfahren und dessen vorteilhafter Ausgestaltungen beschriebenen Berechnungsschritte ausführt.

Die Recheneinrichtung und das die Recheneinrichtung steuernde Softwareprogrammprodukt können sich lokal im Bereich der elektrischen Energieübertragungsleitung befinden; alternativ kann das Softwareprogrammprodukt auch entfernt gespeichert sein, beispielsweise in einer Cloud, und die Recheneinrichtung kann eine entfernte Recheneinrichtung, beispielsweise ein Cloudrechner, sein. Mit anderen Worten kann das lokale Erfassen von Messwerten für die Phase-Erde-Spannungen räumlich getrennt von der Bildung der Phasenspannungszeiger und/oder deren Auswertung erfolgen.

Die Erfindung bezieht sich darüber hinaus auf ein Softwareprogrammprodukt, insbesondere zur Durchführung von Verfahrensschritten des oben beschriebenen Verfahrens und/oder für ein Schutzgerät, wie es oben beschrieben worden ist. Erfindungsgemäß ist bezüglich des Softwareprogrammprodukts vorgesehen, dass das Softwareprogrammprodukt bei Ausführung durch eine Recheneinrichtung diese dazu veranlasst, Phasenspannungszeiger zu bilden, und zwar auf der Basis von Phase-Erde-Spannungen, die für die Phasenleiter der Energieübertragungsleitung gemessen worden sind, mit den Phasenspannungszeigern nach der Methode der Symmetrischen Komponenten drei Systemzeiger, nämlich einen Mitsystemzeiger, einen Gegensystemzeiger und einen Nullsystemzeiger, zu errechnen, unter Heranziehung der Systemzeiger einen Auslösezeiger zu errechnen und auf das Vorliegen eines Doppelerdschlusses zu schließen, wenn der Betrag des Auslösezeigers ein vorgegebenes Betragskriterium erfüllt und der Zeigerwinkel des Auslösezeigers ein vorgegebenes Winkelkriterium erfüllt. Bezüglich der Vorteile des erfindungsgemäßen Softwareprogrammprodukts und dessen vorteilhafter Ausgestaltungen sei auf die obigen Ausführungen im Zusammenhang mit dem erfindungsgemäßen Verfahren und dessen vorteilhafter Ausgestaltungen verwiesen.

Die Erfindung wird nachfolgend anhand von Ausführungsbeispielen näher erläutert; dabei zeigen beispielhaft

Figur 1     einen Leitungsabschnitt einer dreiphasigen Energieübertragungsleitung, anhand derer beispielhaft Ausführungsbeispiele für erfindungsgemäße Verfahren erläutert werden,

Figur 2     einen Auslösebereich für einen Auslösezeiger,

Figur 3     eine Bestimmung der vom Doppelerdschluss betroffenen Phasenleiter anhand eines Quotientenzeigers, und

Figur 4     ein Ausführungsbeispiel für ein erfindungsgemäßes Schutzgerät.

In den Figuren werden der Übersicht halber für identische oder vergleichbare Komponenten stets dieselben Bezugszeichen verwendet.

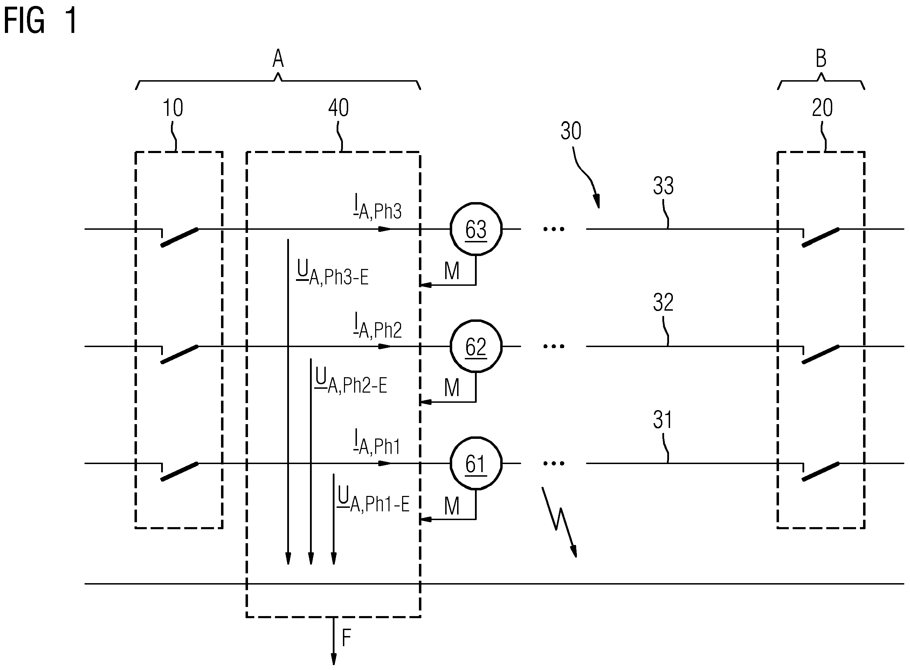

Die Figur 1 zeigt zwei Schalteinrichtungen 10 und 20, die einen Leitungsabschnitt 30 einer dreiphasigen, also drei Phasenleiter 31, 32 und 33 aufweisenden Energieübertragungsleitung begrenzen. Ein nicht gezeigter Sternpunkt der dreiphasigen elektrischen Energieübertragungsleitung ist über eine ebenfalls aus Gründen der Übersicht nicht gezeigte Sternpunktimpedanz, beispielsweise in Form einer Petersenspule, geerdet oder bleibt isoliert.

An einem in der Figur 1 linken Abschnittsende A des Leitungsabschnitts 30 ist ein Schutzgerät 40 über Strom- und Spannungswandler 61, 62 und 63 an die Phasenleiter 31, 32 und 33 des Leitungsabschnitts 30 angeschlossen.

Die Strom- und Spannungswandler 61, 62 und 63 übermitteln Messsignale und/oder Messwerte M, die es dem Schutzgerät 40 ermöglichen, in den Phasenleitern 31, 32 und 33 fließende Ströme bzw. daran anliegende Spannungen messtechnisch zu erfassen. Da bei dem Ausführungsbeispiel gemäß Figur 1 die Strom- und Spannungswandler 61, 62 und 63 an dem linken Abschnittsende A des Leitungsabschnitts 30 angeschlossen sind, bildet dieses linke Abschnittsende A die Messstelle des Schutzgeräts 40.

Unter Heranziehung der mittels der Strom- und Spannungswandler 61, 62 und 63 erfassten Messsignale bzw. Messwerte M berechnet das Schutzgerät 40 zunächst für jeden der Phasenleiter 31, 32 und 33 jeweils einen Phase-Erde-Spannungszeiger, wie dies im Bereich der Schutztechnik allgemein bekannt ist. Die Phase-Erde-Spannungszeiger beziehen sich jeweils auf die Phase-Erde-Spannungen, die für den jeweiligen Phasenleiter der Energieübertragungsleitung an der an dem Abschnittsende A des Leitungsabschnitts 30 befindlichen Messstelle, also an derselben Messstelle, gemessen worden sind.

In der Figur 1 ist für den in der Figur 1 untersten Phasenleiter 31 der Phasenstromzeiger mit dem Bezugszeichen $\underline{I}_{A,Ph1}$ und der Phase-Erde-Spannungszeiger mit dem Bezugszeichen $\underline{U}_{A,Ph1-E}$ gekennzeichnet. Für die beiden anderen Phasenleiter 32 und 33 sind die Phasenstromzeiger mit den Bezugszeichen $\underline{I}_{A,Ph2}$ bzw. $\underline{I}_{A,Ph3}$ und die Phase-Erde-Spannungszeiger mit den Bezugszeichen $\underline{U}_{A,Ph2-E}$ bzw. $\underline{U}_{A,Ph3-E}$ gekennzeichnet.

Mit den Phasenspannungszeigern $\underline{U}_{A,Ph1}$ bis $\underline{U}_{A,Ph3}$ bildet das Schutzgerät 40 nach der Methode der Symmetrischen Komponenten drei komplexe Systemzeiger, nämlich einen komplexen Mitsystemzeiger U1, einen komplexen Gegensystemzeiger U2 und einen komplexen Nullsystemzeiger U0, beispielsweise gemäß

$$U0 \ = \ 1/3 \ \cdot \ (\underline{U}_{A,Ph1-E} + \ \underline{U}_{A,Ph2\_E} + \ \underline{U}_{A,Ph3-E})$$

$$U1 \ = \ 1/3 \ \cdot \ (\underline{U}_{A,Ph1-E} + a \ \underline{U}_{A,Ph2-E} + a^2 \ \underline{U}_{A,Ph3-E})$$

$$U2 \ = \ 1/3 \ \cdot \ (\underline{U}_{A,Ph1-E} + a^2 \ \underline{U}_{A,Ph2-E} + a \ \underline{U}_{A,Ph3-E})$$

mit

$$a \ = \ -\frac{1}{2} + j\frac{\sqrt{3}}{2}$$

Unter Heranziehung der Systemzeiger errechnet das Schutzgerät 40 einen komplexen Auslösezeiger K gemäß

$$K = k \cdot e^{j\alpha} = \frac{U2 \cdot U0}{U1 \cdot U1}$$

wobei k den Betrag des komplexen Auslösezeigers K und $\alpha$ den Zeigerwinkel des komplexen Auslösezeigers K bezeichnet.

Anschließend prüft das Schutzgerät 40, ob der Betrag k des komplexen Auslösezeigers K ein vorgegebenes Betragskriterium erfüllt und der Zeigerwinkel $\alpha$ des komplexen Auslösezeigers K ein vorgegebenes Winkelkriterium erfüllt. Sind beide Kriterien erfüllt, so schließt das Schutzgerät 40 auf das Vorliegen eines Doppelerdschlusses und erzeugt ein Fehlersignal F, das den Doppelerdschluss anzeigt. Vorzugsweise erzeugt das Schutzgerät 40 das Fehlersignal F, wenn sowohl der Betrag k des komplexen Auslösezeigers K einen vorgegebenen Minimalwert Kmin überschreitet als auch (also gleichzeitig) der Zeigerwinkel $\alpha$ in einem vorgegeben Winkelbereich liegt gemäß:

$$\alpha\mathrm{min} > \alpha > \alpha\mathrm{max}$$

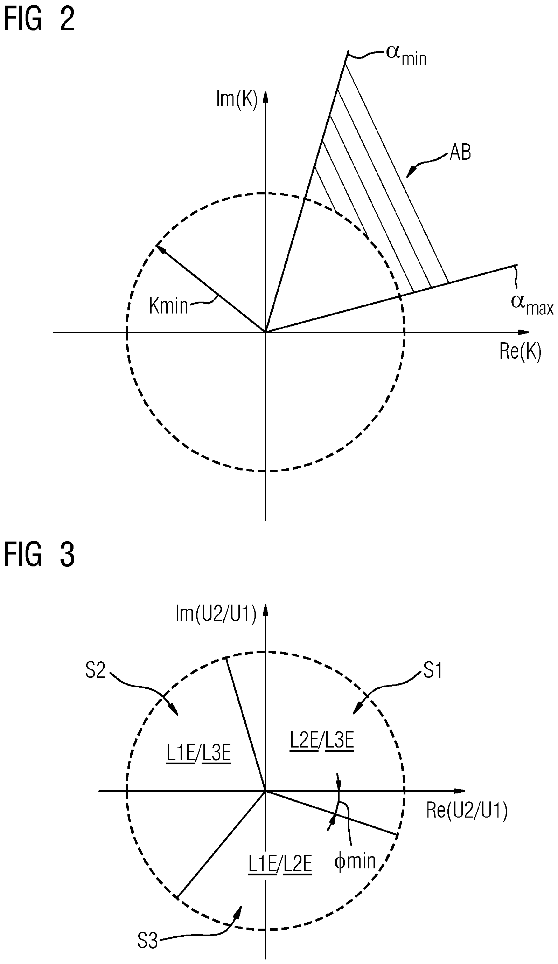

Die Figur 2 zeigt anhand der komplexen Ebene und eines darin markierten Auslösebereichs AB ein Ausführungsbeispiel für die Erzeugung des Fehlersignals F. Liegt der Auslösezeiger K in dem Auslösebereich AB, so wird das Fehlersignal F, das einen Doppelerdschluss anzeigt, erzeugt.

Der Betragsschwellenwert Kmin liegt vorzugsweise zwischen 0,01 und 0,1. Die untere Winkelgrenze $\alpha$min des Winkelbereichs kann beispielsweise -30° und die obere Winkelgrenze $\alpha$max des Winkelbereichs kann beispielsweise +120° betragen.

Liegen ein Doppelerdschluss bzw. das Fehlersignal F vor, so prüft das Schutzgerät 40, welche der Phasenleiter vom Erdschluss betroffen sind. Vorzugsweise bildet das Schutzgerät 40 zu diesem Zwecke einen komplexen Quotientenzeiger Q gemäß:

$$Q = U2/U1$$

und prüft, in welchem von drei vorgegebenen 120°-Kreissektoren S1, S2 und S3 in Figur 3, die gemeinsam einen Vollkreis in der komplexen Ebene bilden, der Quotientenzeiger Q liegt. Anhand der Lage des Quotientenzeigers Q wird auf die zwei vom Doppelerdschluss betroffenen Phasenleiter geschlossen, wie dies durch die Bezugszeichen L1E/L3E, L1E/L2E und L2E/L3E in Figur 3 angedeutet ist.

Liegt der Zeigerwinkel des Quotientenzeigers Q im Bereich $\phi$min bis $\phi$min+120°, also im Kreissektor S1, so sind die Phasenleiter 32 und 33 in Figur 1 vom Doppelerdschluss betroffen, wie das Bezugszeichen L2E/L3E anzeigt.

Liegt der Zeigerwinkel des Quotientenzeigers Q im Bereich $\phi$min+120° bis $\phi$min+240°, also im Kreissektor S2, so sind die Phasenleiter 31 und 33 in Figur 1 vom Doppelerdschluss betroffen, wie das Bezugszeichen L1E/L3E anzeigt.

Liegt der Zeigerwinkel des Quotientenzeigers Q im Bereich $\phi$min+240° bis $\phi$min+360°, also im Kreissektor S3, so sind die Phasenleiter 31 und 32 in Figur 1 vom Doppelerdschluss betroffen, wie das Bezugszeichen L1E/L2E anzeigt.

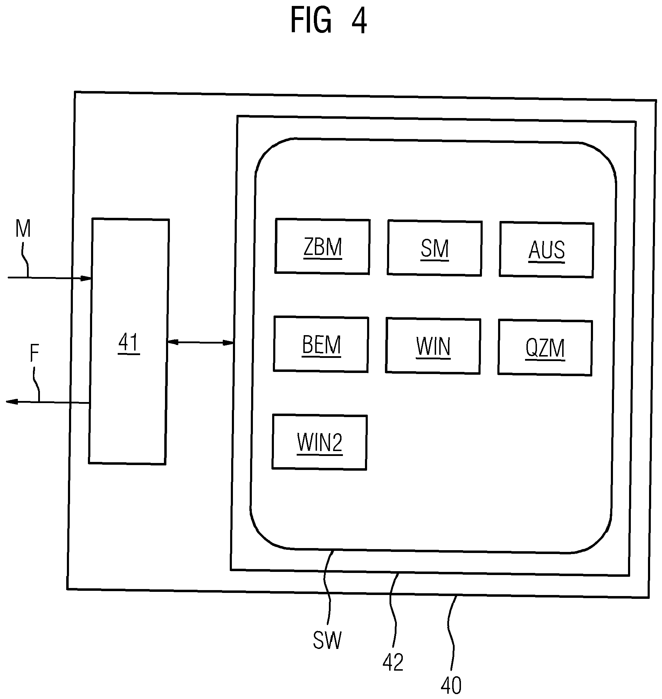

Die Figur 4 zeigt ein Ausführungsbeispiel für ein erfindungsgemäßes Schutzgerät 40. Das Schutzgerät 40 umfasst eine Recheneinrichtung 41 und einen Speicher 42. In dem Speicher 42 ist ein Softwareprogrammprodukt SW abgespeichert, das bei Ausführung durch die Recheneinrichtung 41 die oben im Zusammenhang mit den Figuren 1 bis 3 beschriebenen Berechnungsschritte ausführt.

Zu diesem Zwecke umfasst das Softwareprogrammprodukt SW gemäß Figur 4 vorzugsweise ein Zeigerbildungsmodul ZBM zur Bildung der Phase-Erde-Spannungszeiger $\underline{U}_{A,Ph1-E}$, $\underline{U}_{A,Ph2-E}$ und $\underline{U}_{A,Ph3-E}$ anhand von Abstastwerten, die auf der Basis der Messsignale bzw. Messwerte M der Strom- und Spannungswandler 61, 62 und 63 erzeugt werden oder in diesen bereits enthalten sind.

Außerdem umfasst das Softwareprogrammprodukt SW gemäß Figur 4 ein Symmetriemodul SM, ein Auslösezeigermodul AUS, ein Betragskontrollmodul BEM, ein Winkelkontrollmodul WIN, ein Quotientenzeigermodul QZM und ein weiteres Winkelkontrollmodul WIN2.

Das Symmetriemodul SM dient zur Ermittlung des komplexen Mitsystemzeigers U1, des komplexen Gegensystemzeigers U2 und des komplexen Nullsystemzeigers U0. Das Auslösezeigermodul AUS ermittelt den oben beschriebenen komplexen Auslösezeiger K. Das Betragskontrollmodul BEM prüft das oben beispielhaft beschriebene Betragskriterium. Das Winkelkontrollmodul WIN prüft das Winkelkriterium. Das Quotientenzeigermodul QZM dient zur Erzeugung des oben beschriebenen Quotientenzeigers Q und das weitere Winkelkontrollmodul WIN2 prüft die Lage des Quotientenzeigers Q in der komplexen Ebene. Im Übrigen sei auf die obigen Ausführungen im Zusammenhang mit den Figuren 1 bis 3 verwiesen.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder anderen Unteransprüchen, um weitere andere Ausführungsbeispiele zu erhalten.

**Patentansprüche**

1. Verfahren zum Erkennen eines Doppelerdschlusses in einem Leitungsabschnitt (30) einer dreiphasigen elektrischen Energieübertragungsleitung, wobei bei dem Verfahren

   - Phasenspannungszeiger ($\underline{U}_{A,Ph1}$ - $\underline{U}_{A,Ph3}$) gebildet werden, und zwar auf der Basis von Phase-Erde-Spannungen, die für die Phasenleiter (31-33) der Energieübertragungsleitung gemessen worden sind, und

- unter Berücksichtigung der Phasenspannungszeiger auf das Vorliegen oder Nichtvorliegen eines Doppelerdschlusses geschlossen wird,

**dadurch gekennzeichnet, dass**

- mit den Phasenspannungszeigern ($\underline{U}_{A,Ph1}$ - $\underline{U}_{A,Ph3}$) nach der Methode der Symmetrischen Komponenten drei Systemzeiger, nämlich ein Mitsystemzeiger (U1), ein Gegensystemzeiger (U2) und ein Nullsystemzeiger (U0), errechnet werden,

- unter Heranziehung der Systemzeiger ein Auslösezeiger (K) errechnet wird und

- auf das Vorliegen eines Doppelerdschlusses geschlossen wird, wenn der Betrag (k) des Auslösezeigers (K) ein vorgegebenes Betragskriterium erfüllt und der Zeigerwinkel ($\alpha$) des Auslösezeigers (K) ein vorgegebenes Winkelkriterium erfüllt.

2. Verfahren nach Anspruch 1,
**dadurch gekennzeichnet, dass** der Auslösezeiger (K) eine dimensionslose Größe ist und die Berechnung des Auslösezeigers (K) die Division zumindest zweier der drei Systemzeiger umfasst.

3. Verfahren nach einem der voranstehenden Ansprüche,
**dadurch gekennzeichnet, dass** die Berechnung des Auslösezeigers (K) die Multiplikation zweier der Systemzeiger (U1) unter Bildung eines Zeigerprodukts einschließt.

4. Verfahren nach Anspruch 3,
**dadurch gekennzeichnet, dass** die Berechnung des Auslösezeigers (K) die Division des Zeigerprodukts durch das Quadrat des dritten der drei Systemzeiger einschließt.

5. Verfahren nach einem der voranstehenden Ansprüche 3 bis 4,
**dadurch gekennzeichnet, dass** die Berechnung des Auslösezeigers (K) die Multiplikation des Nullsystemzeigers (U0) und des Gegensystemzeigers (U2) einschließt.

6. Verfahren nach einem der voranstehenden Ansprüche 3 bis 5,
**dadurch gekennzeichnet, dass** die Berechnung des Auslösezeigers (K) die Division des Zeigerprodukts durch das Quadrat des Mitsystemzeigers (U1) einschließt.

7. Verfahren nach einem der voranstehenden Ansprüche,
**dadurch gekennzeichnet, dass** das Betragskriterium als erfüllt angesehen wird, wenn der Betrag (k) des Auslösezeigers (K) größer als ein vorgegebener Betragsschwellenwert (Kmin) ist.

8. Verfahren nach Anspruch 7,
**dadurch gekennzeichnet, dass** der Betragsschwellenwert (Kmin) zwischen 0,01 und 0,1 liegt.

9. Verfahren nach einem der voranstehenden Ansprüche,
**dadurch gekennzeichnet, dass** das Winkelkriterium als erfüllt angesehen wird, wenn der Zeigerwinkel ($\alpha$) des Auslösezeigers (K) in einem vorgegebenen Winkelbereich liegt.

10. Verfahren nach einem der voranstehenden Ansprüche,
**dadurch gekennzeichnet, dass** im Falle, dass auf einen Doppelerdschluss geschlossen wird, ein Quotientenzeiger (Q) gebildet wird, indem

- einer der drei Systemzeiger durch einen anderen der drei Systemzeiger dividiert wird,
- geprüft wird, in welchem von drei vorgegebenen 120°-Kreissektoren (S1-S3), die gemeinsam einen Vollkreis in der komplexen Ebene bilden, der Quotientenzeiger (Q) liegt und
- anhand der Lage des Quotientenzeigers (Q) auf die zwei vom Doppelerdschluss betroffenen Phasenleiter geschlossen wird.

11. Verfahren nach Anspruch 10,
**dadurch gekennzeichnet, dass** der Quotientenzeiger (Q) durch Division des Gegensystemzeigers (U2) durch den Mitsystemzeiger (U1) gebildet wird.

12. Schutzgerät (40) zum Erkennen eines Doppelerdschlusses in einem Leitungsabschnitt (30) einer dreiphasigen elektrischen Energieübertragungsleitung, wobei das Schutzgerät (40) dazu ausgestaltet ist,

- Phasenspannungszeiger ($\underline{U}_{A,Ph1}$ - $\underline{U}_{A,Ph3}$) zu bilden, und zwar auf der Basis von Phase-Erde-Spannungen, die für die Phasenleiter der Energieübertragungsleitung gemessen worden sind, und

- unter Berücksichtigung der Phasenspannungszeiger auf das Vorliegen oder Nichtvorliegen eines Doppelerdschlusses zu schließen,

**dadurch gekennzeichnet, dass** das Schutzgerät (40) derart ausgestaltet ist, dass es

- mit den Phasenspannungszeigern ($\underline{U}_{A,Ph1}$ - $\underline{U}_{A,Ph3}$) nach der Methode der Symmetrischen Komponenten drei Systemzeiger, nämlich einen Mitsystemzeiger (U1), einen Gegensystemzeiger (U2) und einen Nullsystemzeiger (U0), errechnet,

- unter Heranziehung der Systemzeiger einen Auslösezeiger (K) errechnet und

- auf das Vorliegen eines Doppelerdschlusses schließt, wenn der Betrag (k) des Auslösezeigers (K) ein vorgegebenes Betragskriterium erfüllt und der Zeigerwinkel ($\alpha$) des Auslösezeigers (K) ein vorgegebenes Winkelkriterium erfüllt.

13. Softwareprogrammprodukt (SW), insbesondere zur Durchführung eines Verfahrens nach einem der voranstehenden Ansprüche 1 bis 11 und/oder für ein Schutzgerät (40) nach Anspruch 12, wobei das Softwareprogrammprodukt (SW) bei Ausführung durch eine Recheneinrichtung (41) diese dazu veranlasst,

- Phasenspannungszeiger ($\underline{U}_{A,Ph1}$ - $\underline{U}_{A,Ph3}$) zu bilden, und zwar auf der Basis von Phase-Erde-Spannungen, die für die Phasenleiter gemessen worden sind,

- mit den Phasenspannungszeigern ($\underline{U}_{A,Ph1}$ - $\underline{U}_{A,Ph3}$) nach der Methode der Symmetrischen Komponenten drei Systemzeiger, nämlich einen Mitsystemzeiger (U1), einen Gegensystemzeiger (U2) und einen Nullsystemzeiger (U0), zu errechnen,

- unter Heranziehung der Systemzeiger einen Auslösezeiger (K) zu errechnen und auf das Vorliegen eines Doppelerdschlusses zu schließen, wenn der Betrag (k) des Auslösezeigers (K) ein vorgegebenes Betragskriterium erfüllt und der Zeigerwinkel ($\alpha$) des Auslösezeigers (K) ein vorgegebenes Winkelkriterium erfüllt.

FIG 1

EP 4 333 229 A2

FIG 2

FIG 3

# FIG 4

M

F

41

ZBM   SM   AUS

BEM   WIN   QZM

WIN2

SW

42

40